(19) **Europäisches Patentamt / European Patent Office / Office européen des brevets**

(11) **EP 1 673 592 B1**

(12) **EUROPEAN PATENT SPECIFICATION**

(45) Date of publication and mention of the grant of the patent:
**08.02.2012 Bulletin 2012/06**

(51) Int Cl.:
*G04F 10/00* (2006.01)    *G01D 5/48* (2006.01)

(21) Application number: **04821457.1**

(86) International application number:
**PCT/US2004/033848**

(22) Date of filing: **14.10.2004**

(87) International publication number:
**WO 2005/083626 (09.09.2005 Gazette 2005/36)**

(54) **MAGNETOSTRICTIVE SENSOR FOR MEASURING DISTANCES**

MAGNETOSTRIKTIVER SENSOR FÜR DISTANZMESSUNGEN

CAPTEUR MAGNETOSTRICTIF POUR LA MESURE DES DISTANCES

(84) Designated Contracting States:
**DE FR**

(30) Priority: **14.10.2003 US 510818 P**

(43) Date of publication of application:
**28.06.2006 Bulletin 2006/26**

(73) Proprietor: **LORD CORPORATION**
**Cary, NC 27512-8012 (US)**

(72) Inventors:
- **LORD CORPORATION**
  **Cary, NC 27512-8012 (US)**
- **SOUTHWARD, Steve, C.**
  **Apex, NC 27502 (US)**
- **JOLLY, Mark, R.**
  **Raleigh, NC 27603 (US)**
- **FERGUSON, Matthew, K.**
  **Fairview, PA 16415 (US)**
- **FOWLER, Leslie, P.**
  **Albuquerque, NM 87111 (US)**

(74) Representative: **Dunlop, Brian Kenneth Charles et al**
**Wynne-Jones, Lainé & James LLP**
**Essex Place**
**22 Rodney Road**
**Cheltenham**
**Gloucestershire GL50 1JJ (GB)**

(56) References cited:
EP-A- 0 732 598    EP-A- 0 797 105
US-A- 4 972 441    US-A- 5 206 838
US-A- 5 998 991    US-A1- 2003 146 747

**Description**

**Field of the Invention**

The invention relates to measuring pulse propagation time in magnetostrictive sensors.

**Background of the Invention**

There is a need for a system and method of accurately and economically measuring pulse propagation time, particularly there is a need for an accurate method for determining the arrival time of a pulse waveform at a detector. There is a need for a robust system and method of accurately and economically measuring pulse propagation time in magnetostrictive sensors. Magnetostrictive sensors in the form of magnetostrictive sensor longitudinal waveguides having a waveguide length are used to determine the position of a magnetic target along its length. There is a need for an economically feasible method of dynamically measuring the pulse propagation time in a magnetostrictive sensor waveguide to provide an accurate measurement of the position of a magnetic target along the length of the sensor waveguide.

US 2003/0146747 describes a magnetostrictive position measuring system in which the duration of an excitation pulse is corrected as a function of the position of the magnet ascertained

**Summary of the Invention**

The invention includes a method of measuring a magnetorestrictive pulse as claimed in claim 1.

The invention further Includes a magnetostrictive sensor system as claimed in claim 10

It is to be understood that both the foregoing general description and the following detailed description are exemplary of the invention, and are intended to provide an overview or framework for understanding the nature and character of the invention as it is claimed. The accompanying drawings are included to provide a further understanding of the invention, and are incorporated in and constitute a part of this specification. The drawings illustrate various embodiments of the invention, and together with the description serve to explain the principals and operation of the invention.

**Detailed Description**

Additional features and advantages of the invention will be set forth in the detailed description which follows, and in part will be readily apparent to those skilled in the art from that description or recognized by practicing the invention as described herein, including the detailed description which follows, the claims, as well as the appended drawings.

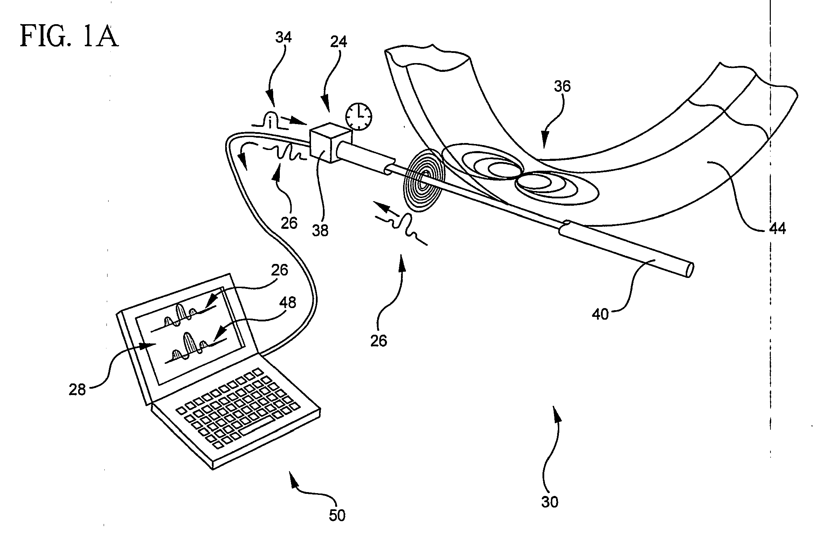

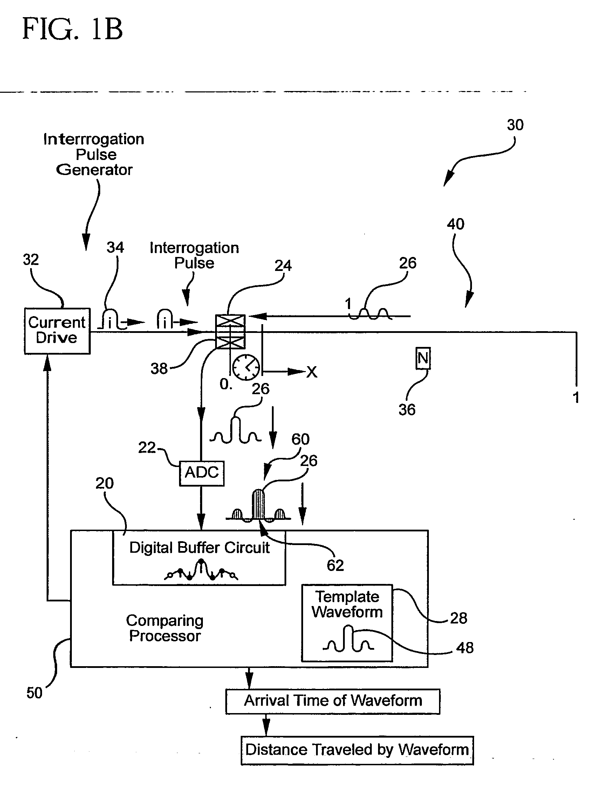

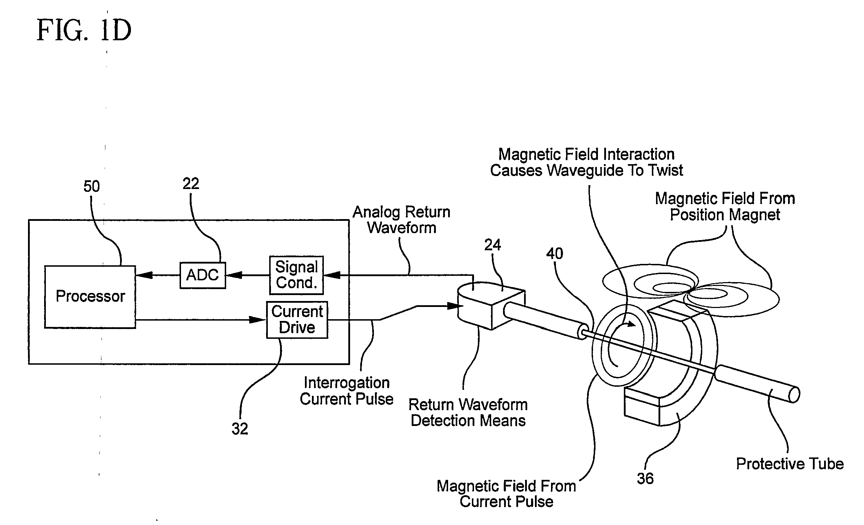

Reference will now be made in detail to the present preferred embodiments of the invention, examples of which are illustrated in the accompanying drawings. The invention includes a method of measuring a magnetostrictive sensor pulse. The method includes the steps of providing a digital buffer circuit connected with an analog to digital converter to an analog waveform detector for receiving a magnetostrictive pulse waveform from a magnetostrictive waveguide, providing a template waveform, receiving a returned magnetostrictive pulse waveform into the digital buffer circuit, and comparing the received pulse waveform with the template waveform to determine an arrival time of the returned magnetostrictive pulse waveform. Preferably providing the template waveform includes providing a synthesized return waveform generated to simulate a characteristic magnetostrictive return pulse waveform of the magnetostrictive system. FIG. 1 illustrates the invention. The method of measuring a magnetostrictive sensor pulse includes providing a digital buffer circuit 20 connected with an analog to digital converter 22 to an analog waveform detector 24 for receiving a magnetostrictive pulse waveform 26 from a magnetostrictive waveguide 40. The method includes providing a template waveform 28, preferably the template waveform 28 is a synthesized return waveform generated to simulate a characteristic magnetostrictive return pulse waveform of the magnetostrictive system 30. The method includes receiving a returned magnetostrictive pulse waveform 26 into the digital buffer circuit 20, and comparing the received pulse waveform 26 with the template waveform 28 to determine an arrival time of the returned magnetostrictive pulse waveform 26 at the waveform detector 24. The method includes providing an interrogation pulse generator 32 coupled to the magnetostrictive waveguide 40, outputting an interrogation pulse 34 from the interrogation pulse generator 32 into the magnetostrictive waveguide 40, wherein receiving the pulse waveform 26 into the digital buffer circuit 20 includes receiving a returned magnetostrictive pulse waveform 26 into the digital buffer circuit 20. Preferably the waveform detector 24 and the buffer circuit 20 are synchronized with the interrogation pulse generator 32 with the comparing processor 50. Preferably the magnetostrictive waveguide waveform detector 24 is comprised of a sense-coil 38. Preferably comparing to determine the arrival time of the returned magnetostrictive pulse waveform 26 at the waveform detector 24 includes determining a time in the received pulse waveform 26 where correlation between the received pulse waveform 26 and the template waveform 28 is at a maximum, to provide for correlating the received pulse waveform 26 with the template waveform 28 to establish the characteristic time of arrival of the returned magnetostrictive pulse waveform 26 to establish the position of the magnetic target 36 along the waveguide 40. Preferably receiving pulse waveform 26 into the buffer circuit 20 includes inputting a measured amplitude 60 at a periodic sampling rate 62, preferably with the periodic sampling rate 62 at least 1 MHz, more preferably about 2MHz, preferably using at least 10 samples per pulse, preferably 10-30 samples per pulse of returned magnetostrictive pulse waveform 26. Preferably outputting an interrogation pulse 34 from the interrogation pulse generator 32 into the magnetostrictive waveguide 40 comprises outputting an interrogation pulse 34 at a rate of at least 0.5 kHz, preferably about 1kHz, and receiving pulse waveform 26 into the buffer circuit 20 includes inputting a measured amplitude 60 at a periodic sampling rate 62 of at least 1 MHz, preferably about 2MHz, preferably using at least 10 samples per pulse, preferably 10-30 samples per pulse. Preferably providing a template waveform 28 includes providing a Mexican hat template waveform 48.

The invention includes a magnetostrictive sensor system 30. The magnetostrictive sensor system 30 includes a magnetostrictive waveguide 40, an analog waveform detector 24 for receiving a magnetostrictive pulse waveform 26 from the magnetostrictive waveguide, and a comparing processor 50 with a template waveform 48 for comparing the received magnetostrictive pulse waveform 26 with the template waveform 28 to determine an arrival time of the returned magnetostrictive pulse waveform 26 at the magnetostrictive sensor analog waveform detector 24. The system 30 is comprised of a digital buffer circuit 20 connected with an analog to digital converter 22 to the analog waveform detector 24 with the digital buffer circuit 20 in communication with the comparing processor 50. Preferably the system 30 is comprised of a magnetostrictive interrogation pulse generator 32 for outputting an interrogation current pulse 34 into the magnetostrictive waveguide 40. Preferably the waveform detector 24 is comprised of a sense-coil 38

The invention includes a method for measuring pulse propagation time. The method includes providing an interrogation pulse generator 32, providing a waveform detector 24 for receiving a returned pulse waveform 26, and providing a template waveform 28. Providing analog waveform detector 24 for receiving a returned pulse waveform 26 includes providing a buffer circuit 20 connected to the detector 24 with an A-D converter 22 to digitally sample and buffer the waveform 26 data for batch data processing by the comparing processor. Alternatively the data from waveform detector 24 can be continuously processed by the processor without buffering up in a buffer circuit 20. Preferably providing the template waveform 28 includes providing a synthesized return waveform generated to simulate a characteristic return pulse waveform of the system 30. The method includes outputting an interrogation pulse 34 from the interrogation pulse generator 32, receiving a returned pulse waveform 26 with the waveform detector 24 into the buffer circuit 20, and comparing the received returned pulse waveform 26 with the template waveform 28 to determine a return arrival time of the returned pulse waveform 26 at the waveform detector 24. Preferably comparing the received returned pulse waveform 26 with the template waveform 28 includes computing where the maximum match or minimum difference is between the received returned pulse waveform 26 with the template waveform 28. Preferably comparing the received returned pulse waveform 26 with the template waveform 28 includes correlating and looking for the maximum of correlation function between the received returned pulse waveform 26 with the template waveform 28. In an embodiment comparing the received returned pulse waveform 26 with the template waveform 28 includes calculating the least mean square fit of the received returned pulse waveform 26 and the template waveform 28. Preferably comparing to determine the return time of the returned pulse waveform 26 includes determining a time in the received return pulse waveform 26 where correlation between the received returned pulse waveform 26 and the template waveform 28 is at a maximum. Preferably receiving returned pulse waveform 26 includes buffering the returned pulse waveform 26 at a periodic sampling rate 62, preferably by inputting a measured amplitude 60 into a buffer circuit 20 at the periodic sampling rate. Preferably the method includes determining a sample time of an amplitude extremum 60 (positive or negative peak) of the buffered returned pulse waveform 26, and preferably establishing a search window around the determined sample time amplitude extremum 60, and estimating a wavelet translation within the established search window wherein a correlation between the template waveform 28 and the received return pulse waveform 26 is maximized. Preferably the method includes providing a buffer circuit 20 and receiving returned pulse waveform 26 includes receiving the returned pulse waveform 26 into the buffer circuit 20 preferably by inputting a sampled voltage at a periodic sample time. Preferably the interrogation pulse generator 32 utilizes different energy domain than the energy of the returned pulse waveform 26 and its detector 24, such as electrical current pulse 34 versus mechanical torsional wave 26 in magnetostrictive waveguide wire 40, with a difference in energy wave speed, such as the speed of light versus the speed of sound in a solid waveguide material. Preferably electrical interrogation pulse 34 out of generator 32 starts the clock of processor 50 and measures the time delay for the mechanical torsional wave 26 to arrive at detector 24 to determine the position of magnetic target 36 along the waveguide 40 from the known speed of waveform 26 so the computed time can be used to compute position along waveguide 40.

Magnetostrictive displacement transducer sensor system use in high temperature severe environments such as in vehicular propulsion systems such as with the Joint Strike Fighter F-35B Lift Fan Shaft (JSF application) has been hindered because the zero-cross detection electronics which are required to be in close proximity to the transducer cannot reliably function at high temperatures. The invention provides for significantly extending the operating temperature range of magnetostrictive transducers by eliminating most of the electronics required at the transducer. This invention also provides a means for significantly improving the accuracy of position measurements in the presence of uncorrelated noise. Furthermore, this invention enables accurate digital signal processing of magnetostrictive sensor signals at low sample and clock rates as compared to that required for zero-cross or threshold detection schemes.

Magnetostrictive (MS) sensors have characteristic analog return waveforms. Raw experimental magnetostrictive sensor response waveforms were acquired from a commercially available magnetostrictive position sensor and a commercially available magnetostrictive displacement transducer. From this data, a set of synthesized waveform templates was constructed which fairly accurately represented the raw waveforms. The synthesized waveforms were then used to simulate a typical response of an MS sensor in a V/STOL fixed wing aircraft engine lift fan propulsion system flexible coupling sensor rigid collar misalignment measuring system for measuring angular alignment of propulsion system drive shaft coupling angular alignment. The use of synthesized template waveform allowed for exact knowledge of the "characteristic time" associated with each returned pulse waveform. The estimated characteristic times were within 0.5 nanosecond of the exact times with no additive noise. When normally distributed noise was added to the simulations, the timing errors were normally distributed and still very small (<10ns) verifying robustness and accuracy of the method.

Preferably the invention is utilized in pulse timing applications to measure pulse propagation time. In a preferred embodiment the invention is utilized for precision position measurements with magnetostrictive transducers in a magnetostrictive sensor system to measure a position of a target. Specific implementation details are disclosed below in reference to the Joint Strike Fighter Lift-Fan Shaft Prognostics and Health Monitoring application for measuring angular alignment (JSF application), such as described in U.S. Provisional Patent 60/374,752 filed 04/23/2002 (Attorney Docket No. IR-3272 (MC))(Misalignment measuring system using magnetostrictive linear sensors) and U.S. Patent Application 10/421,325 filed 04/23/2003 (Attorney Docket No. IR-3272)(Aircraft Vehicular Propulsion System Monitoring Device and Method) U.S. Patent Application Publication US 2004/0024499 A1, Publication Date Feb. 5, 2004.

In the operation of a magnetostrictive sensor system 30 for measuring the position of a target 36 an interrogation current pulse 34 is applied to the magnetostrictive waveguide 40 within the sensor with an interrogation pulse generator 32. This current establishes a toroidal magnetic field around the waveguide. This magnetic field interacts with magnetic fields generated by magnetic targets 36 and creates torsional waves within the waveguide. These torsional waves propagate back to the origination end whereby they are detected with a waveform detector 24 (preferably a sense-coil 38), producing a returned pulse waveform 26. A separate return waveform 26 will be detected for every distinct magnetic field present along the waveguide 40.

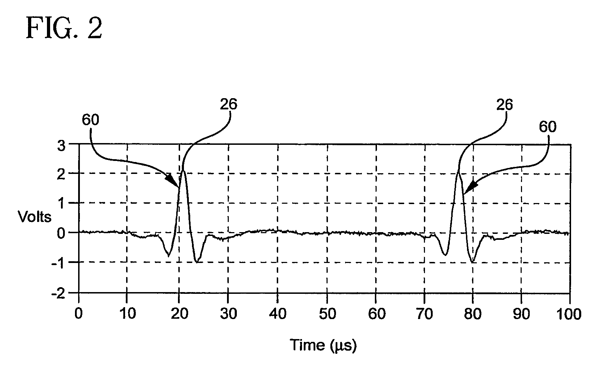

FIG. 2 shows a typical raw analog returned waveform 26 sensed by the waveform detector 24. This signal contains two distinct pulse return waveforms 26 due to the positioning of two distinct permanent magnets targets 36 at separate locations along the magnetostrictive sensor transducer waveguide 40. Knowing the (constant) wave speed of the torsional waveforms, we can accurately estimate either the absolute or relative positions of the magnets from the characteristic timing of the returned pulse waveforms 26.

Previous measurement systems have utilized a threshold or zero-crossing detector to ascertain the characteristic timing of the return waveforms. The zero-crossing detection circuitry is commonly implemented in analog electronics which are physically placed in close proximity to the magnetostrictive transducer itself. Only the output of the zero-crossing detection circuitry has been represented digitally as a logical 1 or 0. The invention eliminates the zero-crossing detection circuitry and utilizes a simple buffer circuit 20 with the return waveform detector (magnetostrictive return waveform detector 24). This simple buffer circuit 20 can tolerate the high temperature environment of the Joint Strike Fighter Lift-Fan Shaft Prognostics and Health Monitoring system. Preferably for this invention, the analog return waveform is signal conditioned, then digitally sampled and processed on a remotely located processor 50 to determine the characteristic timing. FIG. ID shows a system schematic of this architecture using a magnetostrictive transducer.

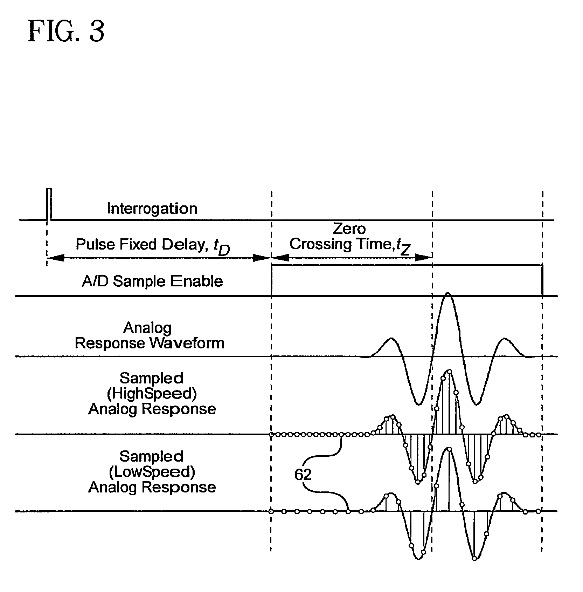

For the Joint Strike Fighter Lift-Fan Shaft Prognostics and Health Monitoring application, each magnet target 36 has a fixed and known operating range of motion that translates to a fixed and known time window within which the associated return pulse will occur. As the timing diagram of FIG. 3 indicates (for a single return pulse), the A/D converter 22 is only enabled during the known time window, i.e. after a fixed time delay. The zero-crossing time is also shown in FIG. 3 for reference.

The lower curves in FIG. 3 represent two alternative digital sampling schemes with a high speed periodic sampling rate 62 and a low speed periodic sampling rate 62. In the first example, a high-speed sample process captures data with a relatively high time resolution. Rather than rely on the integrity of a relatively small and inherently noise-prone subset of the sampled data (i.e. near zero crossings such as by determining the characteristic time from the high-speed digitally sampled data by looking for zero crossings in the data), this invention takes advantage of the entire buffer of data.

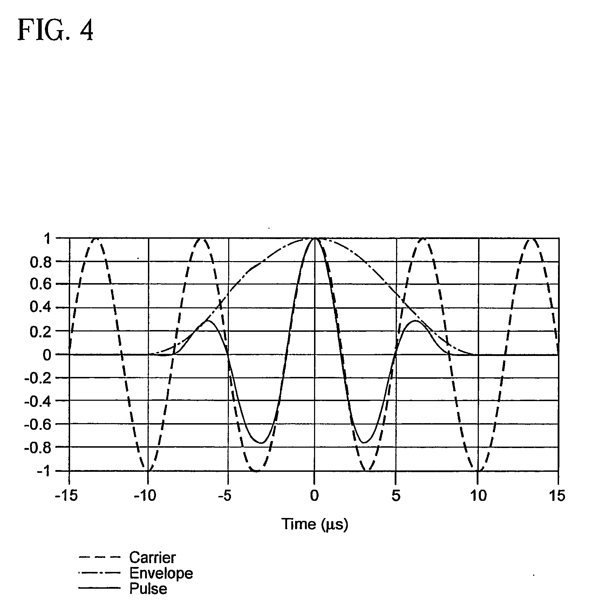

The preferred sampling approach for determining the characteristic time using the digitally sampled data is represented by the lower plot in FIG. 3, where the waveform is sampled at a low speed, providing a coarse time resolution. Preferably, the minimum sample rate should satisfy the Nyquist criterion for the return pulse. Based on typical return waveforms data as well as experimental measurements from commercially available magnetostrictive devices, the return waveforms can approximately be characterized as having a *carrier* frequency which is modulated by some finite duration *envelope* to form the resultant *pulse* as indicated in FIG. 4.

Typical magnetostrictive carrier frequencies range from 150 kHz to 350 kHz with envelope durations typically between 10 $\mu$s and 20 $\mu$s. A well-designed low speed periodic sample rate for this range of carrier frequencies is 2.0 KHz, resulting in about 6 to 13 samples per period of the carrier frequency. A typical interrogation current pulse rate is around 1 kHz, and a typical wave speed is about 10 $\mu$s/inch.

The return waveform pulse in FIG. 4 is shown symmetric about its center. This need not be the case in practice as governed by the symmetry of the envelope. Symmetric, anti-symmetric; and non-symmetric pulses are all handled by this invention. Note that the envelope has a finite extent in time, and outside of the envelope, the pulse is considered to be zero.

The typical return pulse waveforms from a magnetostrictive sensor have a similar resemblance to wavelet templates. A proper wavelet $\psi$ ($t$) is a zero-mean continuous function with a finite extent which, when used in a signal processing framework, is dilated with a scaling parameter s and translated in time by $\tau$.

$$\psi_{\tau,s}\left(t\right) = \psi\left(\frac{t-\tau}{s}\right) \qquad (1)$$

The scaling parameter stretches or compresses the time scale whereas the translation parameter offsets the wavelet in time. The invention includes the application of wavelets to the measuring of absolute or relative pulse timing in a magnetostrictive sensor by comparing and correlating the received returned pulse waveform 26 with the wavelet template waveform 28. Preferably maximum correlation between the template waveform 28 and the returned pulse waveform 26 is utilized to determine the return arrival time of the returned pulse waveform.

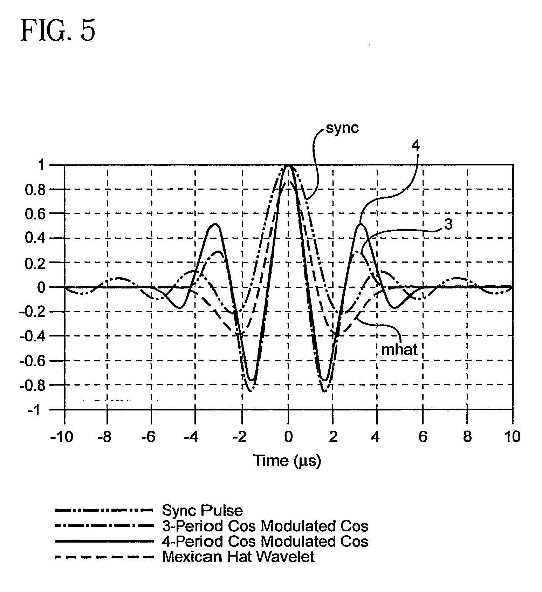

Preferably with this invention the variable scaling parameter is not utilized since the pulses generally always have a constant carrier frequency. A constant scaling can always be chosen for a given sensor type. It is also not required for this invention to use a mathematically proper wavelet, i.e. one that satisfies all the formal properties of a true wavelet. FIG. 5 shows a plot of four example wavelets that were used to verify the accuracy and robustness of this invention. In general, an appropriate wavelet template waveform should be chosen with respect to the characteristic return waveform for a particular sensor. The method of this invention is highly robust to the selection of wavelet template type, its amplitude and carrier frequency, and the amplitude variations of the raw signal itself. Each of the wavelets in FIG. 5 produced very similar results when used for determining the characteristic timing of the magnetostrictive return pulses.

The preferred embodiment for the Joint Strike Fighter Lift-Fan Shaft Prognostics and Health Monitoring application is to interrogate each magnetostrictive sensor at a 1 kHz rate (1000 $\mu$s sample period) and to digitally sample the data at a rate of about 2 MHz (about 0.5 $\mu$s sample period, 0.5 $\pm$ .25 $\mu$s sample period), most preferably 1.548 MHz (.646 $\mu$s sample period). Note that two target magnets per sensor are present for this application with two return waveforms as shown in FIG. 2. Preferably the following steps are repeated in sequence at the interrogation rate:

**Step 1**:    Outputting an interrogation current pulse 34 (1 $\mu$s duration) to the magnetostrictive transducer waveguide 40

**Step 2**:    Wait for the first returned pulse 26 (22.5 $\mu$s or about 45 samples (45$\pm$25 samples) of the ADC clock, most preferably about 21 samples)

**Step 3**:    Enable the ADC 22 and buffer up data (15 $\mu$s or 30 samples of the ADC clock)

**Step 4**:    Wait for the second returned pulse 26(45 $\mu$s of about 90 samples (90$\pm$45 samples) of the ADC clock, most preferably about 47 samples)

**Step 5**:    Enable the ADC 22 and buffer up data (15 $\mu$s or 30 samples of the ADC clock)

At this point we have two separate buffers of digitally sampled data containing the returned pulse waveforms corresponding to the two magnetic targets. Next we process these buffers to determine the characteristic timing for each one. For each buffer:

**Step 6**:    Determine the index (sample number) of the peak or central value in the data.

**Step 7**:    Establish a search window (2-4 samples) around the index determined from Step 6.

**Step 8**:    Estimate the wavelet template waveform translation time $\tau$ within the established search window that maximizes the correlation between the translated template wavelet and the sampled data.

Preferably here we implicitly define the characteristic timing to be the optimal translation time. Once the optimal wavelet template translation times are determined for each of the two buffers, the pulse-to-pulse (relative) timing, or interrogation-to-pulse (absolute) timing can be computed using knowledge of when the buffers were sampled relative to the interrogation pulse.

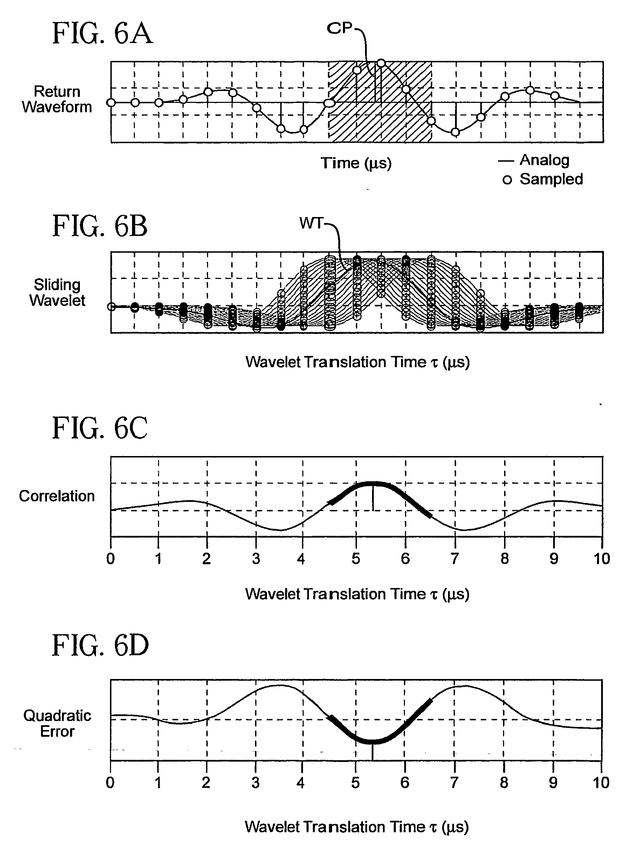

Preferably the invention includes the implementation of Step 8. There are several ways of implementing Step 8 to achieve a desired accuracy and robustness level. To clarify this method further, we begin with a brute force approach applied to the example shown in FIG. 6.

The upper plot in FIG. 6 represents an example analog return waveform that has been digitally sampled as a buffer of 20 samples. For this example, a symmetric cosine-modulated cosine wavelet (see FIG. 5) was selected to represent the synthesized return template waveform 28. We can define the center point of this wavel et to be the characteristic time as indicated by the vertical line CP in the upper plot FIG. 6A. Notice that the characteristic time generally does not occur at one of the sample times.

The objective of Step 8, for this example; is to determine the characteristic time using only the 20-sample time buffer data as input by comparing the received returned pulse waveform with the wavelet template waveform. Define the digitally sampled return waveform buffer to be:

$$\mathbf{r} = \begin{bmatrix} r_1 & \cdots & r_n & \cdots & r_{20} \end{bmatrix}^{\mathrm{T}} \qquad\qquad (2)$$

Applying Step 6 to the example buffer in FIG. 6, we see that the peak value in the data occurs at sample number 12. From Step 7, we next establish a search window of two samples on either side of the peak, as indicated by the shaded crosshatched region in the plot of FIG. 6A. To implement Step 8, we first select a wavelet template 28 that approximates the sampled return pulse waveform. For this example, the Mexican Hat wavelet template was chosen.

We next select a translation time $\tau$ such that the wavelet template is centered at the leftmost edge of the search window. A second buffer of data is generated by numerically sampling the continuous wavelet template to match the temporal sampling of the returned waveform buffer. Define the digitally sampled wavelet template buffer to be:

$$\mathbf{w}(\tau) = \begin{bmatrix} w_1 & \cdots & w_n & \cdots & w_{20} \end{bmatrix}^{\mathrm{T}} \qquad\qquad (3)$$

Using these two buffers, we next compute a performance metric, such as a *correlation* function or a *quadratic error* cost function to compare the received returned pulse waveform with the template waveform. These two metrics are defined as:

$$J_{correlation}(\tau) = \mathbf{w}(\tau)^{\mathrm{T}} \mathbf{r} = \mathbf{r}^{\mathrm{T}} \mathbf{w}(\tau) \qquad\qquad (4a)$$

$$J_{quadratic}(\tau) = \left(\mathbf{w}(\tau) - \mathbf{r}\right)^{\mathrm{T}} \left(\mathbf{w}(\tau) - \mathbf{r}\right) \qquad\qquad (4b)$$

In the case of the correlation metric (4a), we wish to determine the translation time that maximizes the metric (FIG. 6C), and in the case of the quadratic error metric (4b), we wish to minimize the metric (FIG. 6D). Both comparisons lead to complementary results as indicated in FIG. 6C-D.

At this point we only have a single point in our performance metric. In order to find the minimum (or maximum), we need to compute more points. One way to do this is to "slide" the wavelet template from the leftmost edge of the search window to the right most edge in small discrete time steps, while computing the comparing performance metric at each translation time. The time steps for sliding the wavelet template should be chosen at the same resolution as the desired accuracy of the measurement. An example of this wavelet sliding process is depicted in FIG. 6B.

Once the performance metric is computed over the search window, it is easy to find a comparing extremal value, i.e. a minimum or maximum. As long as the search window is not chosen too large, the extreme point will be unique. The translation time associated with the extreme metric is the characteristic time that maximizes the correlation between the wavelet and the sampled data. For this example, the wavelet template with the optimal translation time is highlighted in bold and labeled WT in the plot of FIG. 6B.

As mentioned above, this brute force method will certainly produce a desirable result, but at considerable computational expense. A significant portion of that expense comes from direct evaluation of the continuous wavelet function to generate the sampled wavelet data buffer of equation (3). One potential means for reducing this expense is to pre-compute a set of sampled wavelet templates at a fine translation time resolution, but only sliding the wavelet from one sample period to the next sample period of the raw waveform sample rate. Mathematically, we can pre-compute the following matrix:

$$\mathbf{W} = \begin{bmatrix} w(kt_s) & w(kt_s + \Delta\tau) & w(kt_s + 2\Delta\tau) & \cdots & w((k+1)t_s) \end{bmatrix} \qquad (5)$$

where $t_s$ is the sample period of the low-speed sample process, $k$ is the low-speed sample index, and $\Delta\tau$ is the incremental translation time offset for each step. The data in this matrix can be used to cover a range of translation times either with appropriate zero padding or by extracting an appropriate subset of data.

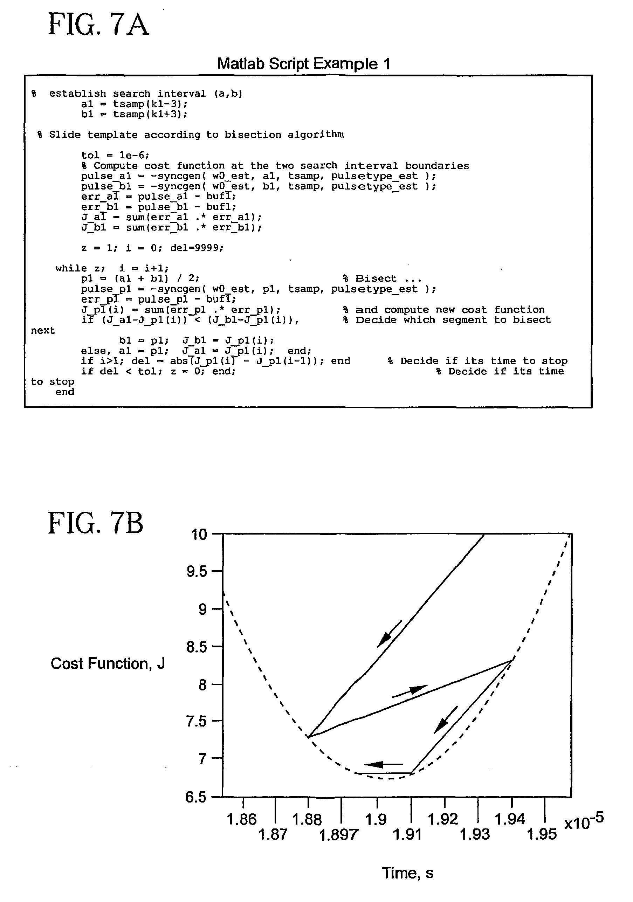

Another significant portion of the computational expense comes from the generation of the performance metric over a range of translation times. Considerable computational savings can be realized using the bisection method to search for optimal wavelet alignment rather than brute-force sliding. The bisection method entails continuously subdividing the search interval until changes in the subsequent cost function calculations drop below a defined threshold. FIG. 7A is an example Matlab script for sliding a wavelet template waveform 28 (*syncgen*) over the buffered data (*buf1*) of a received returned pulse waveform 26 according to the bisection method.

The method was applied to actual returned pulse waveforms 26 produced from a commercially available magnetostrictive sensor. FIG. 7B is an example from a typical data set showing how the bisection method searches the cost function for the minimal value. In this example, the computation steps were reduced by two orders of magnitude (to 10-15 temporal moves of the wavelet). Note from FIG. 7B that the bisection method does not always step in the optimal direction. Consequently, more sophisticated algorithms can be employed that further reduce the computational steps by a factor of two or so. But these typically require more computationally intensive estimations of a gradient - the bisection method is, in comparison, computationally simple.

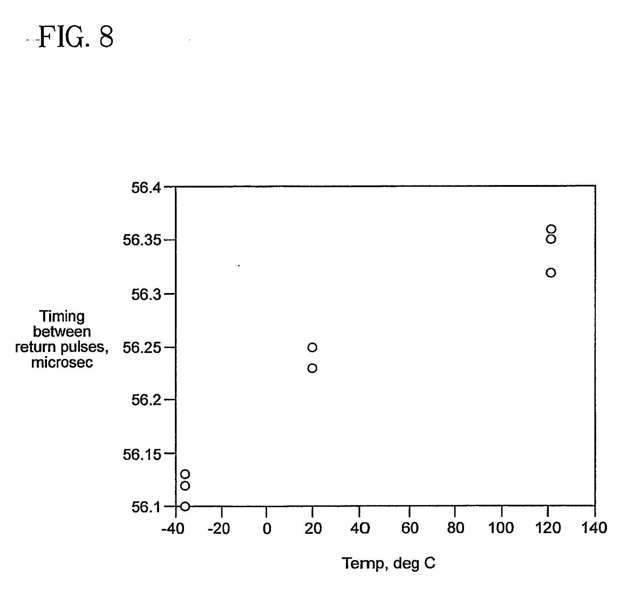

The present invention provides for extending the temperature range of magnetostrictive probes and allowing improved accuracy and precision in magnetostrictive measurements. FIG. 8 shows the present invention applied to data taken on a commercially available magnetostrictive sensor 40. Three data points were taken at each of three temperatures. The y-axis corresponds to the time between two pulses corresponding to two magnets 36 located along the magnetostrictive sensor waveguide probe at about 168 mm apart. The value spread at any given temperature is less than 0.05 $\mu$s corresponding to less than 0.15 mm. The slope of the data points with temperature is consistent with typical magnetostrictive wave speed temperature coefficients of about 2-3 ppm/in/°F. Typical magnetostrictive sensor waveguide probes have a maximum upper temperature use range no greater than 100°C because of decreased signal amplitude and quality at temperature extremes. The present invention is shown to provide calibration-worthy results above 100°C, and preferably up to 121°C.

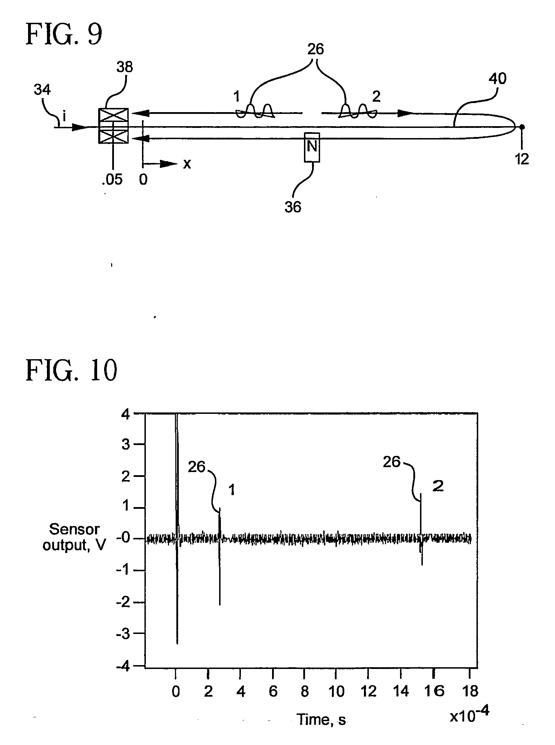

A schematic of a magnetostrictive sensor is shown in FIG. 9. A magnetostrictive waveguide wire 40 passes through a sense coil 38. Interrogation pulses 34 are applied to the magnetostrictive waveguide wire 40 creating a toroidal magnetic field. This magnetic field interacts with a target position magnet 36 and creates torsional waves that travel in both directions along the waveguide 40 from the location of the magnet 36. Torsional wave 1 first passes through the sense coil 38 followed by torsional wave 2 after reflection (and inversion) off the end of the wire 40. FIG. 10 shows a typical sense coil output 38. The first large response corresponds to the current interrogation pulse 34 passing through the coil 38 (this will be referred to as current noise), followed by returned waveform pulses 26 corresponding to torsional waves 1 and 2.

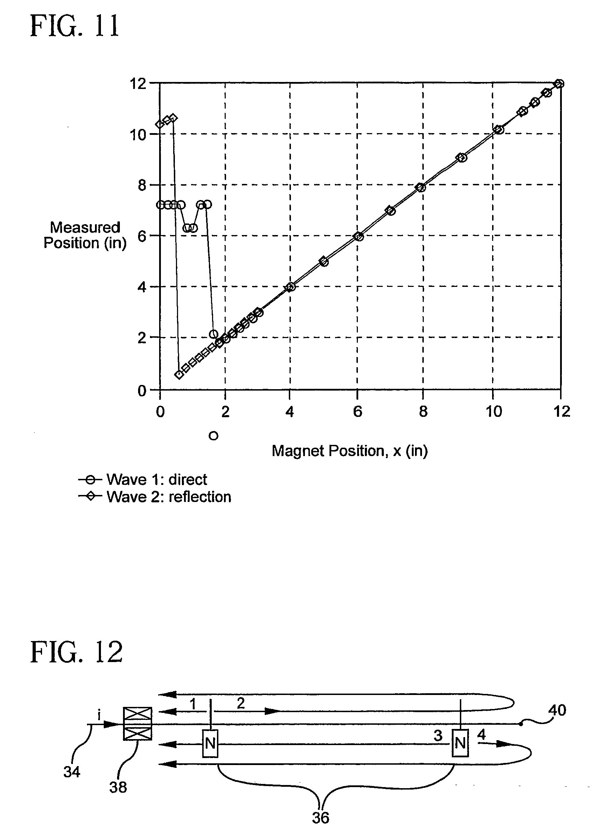

As the magnetic target 36 moves close to the coil 38, wave 1 begins interacting with and ultimately becomes buried in the current noise. For a typical magnetostrictive sensor, this interaction forces a dead-zone within 2.5 inches of the coil. However, this dead-zone can be reduced substantially by using wave 2 instead of wave 1 for timing purposes, particularly when the target magnet 36 is near the coil 38. FIG.11 illustrates this and shows the reduction in dead zone resulting from use of the end of the waveguide reflected waveform. Magnet position x=0 corresponds to a magnet position at about 0.5 inches from the sense-coil center. Therefore, it can be seen that using the reflected wave 2 allows measurement to a point at about 1.0 inch from the coil, whereas use of wave 1 allows for a reasonable measurement only beyond about 2.5 inches from the coil.

The template waveform comparison signal processing of the invention is effective at nearly eliminating the dead-zone on the termination end of the magnetostrictive sensor waveguide probe.

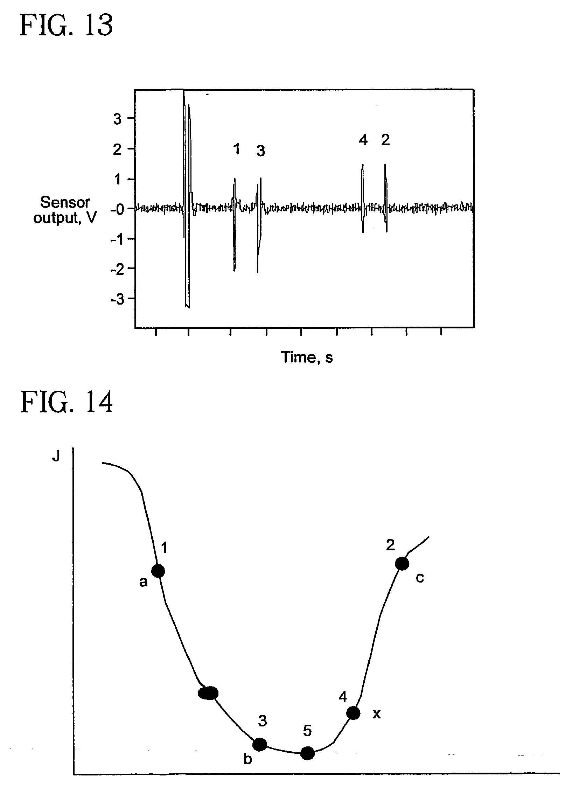

For the coupling angular misalignment measurement Joint Strike Fighter Lift-Fan Shaft Prognostics and Health Monitoring application, two magnetic targets 36 are used. Therefore the sensor schematic and corresponding coil output look like that shown in FIG. 12 and 13. FIG. 12 illustrates the propagation of torsional waves in magnetostrictive waveguide sensor 40 with two target magnets 36. FIG. 13 shows the four returned waveform-pulses from the two target magnets 36. Based on the above discussion it is preferred to use torsional wave 2 to minimize the sensor dead length. Since the other magnet is not proximal to the coil 38, either wave 3 or 4 may be used. Therefore the distance between the two magnets may be calculated by:

$$d = c\left(t_2 - t_4\right) \qquad\qquad (6)$$

where $t_2$ -$t_4$ is the relative timing between waves 4 and 2, and c is the material wave- speed. The other torsional waves (1 and 3) are preferably used to corroborate the measurement. In a preferred embodiment torsional waves 1 and 3 are used to determine the position of the two target magnets 36 in that these received returned pulse waveforms have larger amplitudes, such as shown in FIG.12 and 13.

The length of the interrogation current pulse 34 is preferably on the order of 1-2 $\mu$s in duration, such as 1 $\mu$s $\pm$ 10 ns or 1.15 $\pm$ 0.15 $\mu$s. Methods such as zero-cross detection would have a problem with such variability in the interrogation pulse but the robustness of the present invention provides for such a large range tolerance. Preferably the interrogation pulse duration is in the range of about .9-2 $\mu$s. Preferably the interrogation pulse has a variable interrogation pulse duration with the magnetostrictive interrogation pulse generator providing for the output of a pulse duration in the range of about .9-2 $\mu$s.

The method of template waveform comparison utilizes searching to find the characteristic times. The bisection method is a method for root finding. This is not what is necessarily needed using template wavelets with magnetostrictive sensors since we are not necessarily looking for zero-crossings. In practice we wish to find the time at which a template wavelet best matches the buffered data. Thus it is a correlation and we wish to maximize the correlation to find the optimal and very accurate characteristic time. Finding the maximum of this correlation function is a one-dimensional maximization problem in which one preferably brackets the maximum.

One method for minimization or maximization of a function in one dimension is the Golden Section Search. In both the bisection and Golden Section Search methods one preferably brackets the solution. The subtle difference between the two methods is that in bisection, the solution, or root, is bracketed by a pair of points, a and b, when the function has opposite signs at those two points. For the minimization or maximization problem one cannot rely on a zero-crossing or root. Instead one preferably defines three points such that a < $b$ < c such that f($b$) < f(a) and f($b$) < f($c$).

Finding the minimum or maximum of a function can be reduced to a root-finding problem if one takes the derivative of the function. In that case the bisection method can be employed as an alternative embodiment.

For continuous functions the solution is not bounded by the processor's floating-point precision. It is given by Taylor's theorem $f(x) \approx f(b) + 1/2 \cdot f''(b)(x - b)^2$ and understanding this equation helps to minimize the total number of bisections allowed. A typical value used for the search tolerance is the square root of the processor's floating-point precision.

While many bisection and Golden Section Search method solutions will ultimately be bounded by some small floating point number due to the continuous nature of the function, the discrete nature of this invention implies that the solution is bounded by discrete sampling points. FIG. 14 (Minima Search for Cost Function J) shows a Golden Section Search for the minimum of a cost function J.

The comparing search method preferably begins by choosing points 1, 2, and 3 such that f(3)<f(2) and f(3)<f (1). Then a point 4 is chosen either in between points 1 and 3 or points 3 and 2. We find that f(4) < f(2) but f(4) > f(3). Therefore point 3 is still the middle point in our search but the outer bounds are now points 1 and 4. Now choose a point between points 1 and 3 or points 3 and 4. We find that f(5) < f(3) and f(5) < f(4) so this becomes our new middle point. In all cases the middle point of the new set of three points is the point whose ordinate is the best minimum achieved so far. Now we must choose a point between points 3 and 5 or 5 and 4. The comparing search is terminated when a predetermined number of search iterations have been completed (to limit processor burden) or when either the minimum has been bounded by some criteria on the abscissa, or the distance between interior points is greater than the inverse of the number of precomputed wavelet buffers.

In this search the points 1, 2, 3, and 4 can be floating point numbers. However the abscissa is then discretized to the basis corresponding to the number of wavelet buffers so that the appropriate wavelet is used to evaluate the cost function.

With the Golden Section Search method the choice of the point 'x' (as shown in FIG. 14) should be 38.197 % (the golden ratio) of the distance from the middle point in the search window into the larger of the two intervals a-b and b-c. Regardless of the initial conditions of the search, it will converge to this ratiometric searching so long as successive points are chosen using the golden ratio rule. The convergence to a minimum is linear and not quite as good as the bisection method (which uses a ratio of 50%).

In the Joint Strike Fighter Lift-Fan Shaft Prognostics and Health Monitoring application we know the physical configuration of the magnetostrictive sensor 40 and the target magnet 36 in the system we choose the outer brackets 'a' and 'c'. These points are the beginning and ending samples of our search window (as described in Step 7 above). We choose a point 'b' within this bracket for the third point and then apply the golden section search. Since we must compute the peak value in the search window in the Joint Strike Fighter Lift-Fan Shaft Prognostics and Health Monitoring application, we can use this as point 'b'.

There are many other numerical methods that can be used to solve the one-dimensional minimization problem (and many more for multidimensional problems) for comparing the returned pulse waveform 26 with the template waveform 28. For example, Brent's method is quicker than the Golden Section Search method but fails if the three chosen points are collinear. For this reason both methods are preferably employed together in practice using logic to switch between the two as required.

A more computationally burdensome method is the brute-force method in which the cost function is analyzed for every precomputed wavelet buffer.

Whichever search method is employed, the characteristic time is the time corresponding to the wavelet centroid for which the cost function is minimized (or the correlation function is maximized).

The comparison of the returned pulse waveform 26 with the template waveform 28 provides beneficial signal processing of time-of-flight data. Preferably the signal processing of time-of-flight data includes two main steps: (1) digital accumulation of return pulses which typically occurs over the duration of multiple shots or interrogations, and (2) identification of a characteristic time associated with the accumulated return pulses, preferably the returned pulse waveform centroid. Methods A-C pertain to Step (1). Method A is the pulse accumulation method for which multiple shots (interrogations) are executed and the return pulses are accumulated (averaged) on an ensemble-basis. For example, if 20 shots are executed and each shot consisted of 16k points, the accumulated result is 16k points. With such a method, zero-mean noise that is both stationary and ergodic over short time frames will vanish as the number of accumulations N gets large. With sufficiently large N, the resolution $\varepsilon$ of this method is generally

$$\varepsilon \sim \pm c/2f_s$$

where c is the propagation speed and $f_s$ is the sample rate.

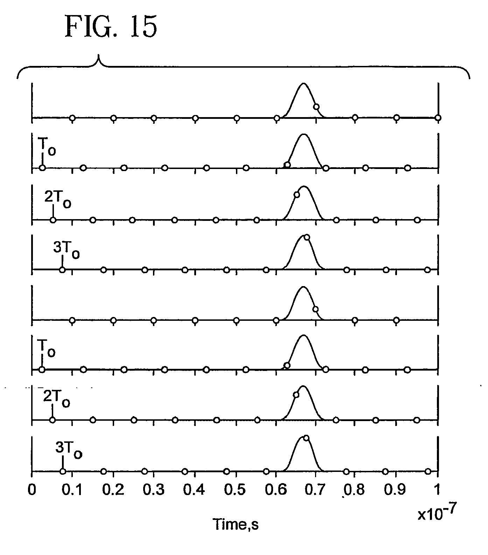

Method B is similar to Method A but employs two characteristic times: the sample period $T_s = 1/f_s$ and a counter period To where, typically $T_o = m\,T_s$ where m >1 is a scalar. Again, N shots and accumulations occur, except that the A/D is delayed one count period To for each shot. The counter has a very low bit count M such that it rolls over N/M times within N. The result is an effective (accumulated) sample period of $T_s/M$ and N/M points to be averaged at each of the effective sample times. It is clear that this interleaving method can be very effective at resolving the return pulse as M increases. In the example shown in the FIG. 15, N = 8 and M = 4 (2-bits), such that the effective sample period is $T_s/4$ with 2 samples at each effective sample time. Method B allows for the use of a lower rate A/D with the inclusion of a very fast (but low bit) counter. The resolution $\varepsilon$ of this method is generally

$$\varepsilon \sim \pm c /2Mf_s$$

Method C is similar to Method B except that the A/D initiation time is random within the interval (0, $T_s$). The motivation for this method is to achieve some of the benefits of Method B without the need for a high-speed counter.

An alternative to varying the A/D initiation time, as is done in Methods B and C, is to vary the interrogation period from which the A/D buffering is triggered.

The wavelet template waveform comparison method of the invention is beneficial compared with a peak-detect approach. With each of the above methods, one would generally attempt to define the characteristic time of the accumulated return pulse by identifying the time associated with the centroid of the pulse. One method of doing this would be to simply identify the time associated with the peak value of the return signal. If after accumulation, the sampled return pulse substantially emerges from the noise floor, then the worst-case accuracy will correspond to the resolution defined above. Improved accuracy is provided by using the wavelet template waveform comparison method to identify the return pulse centroid.

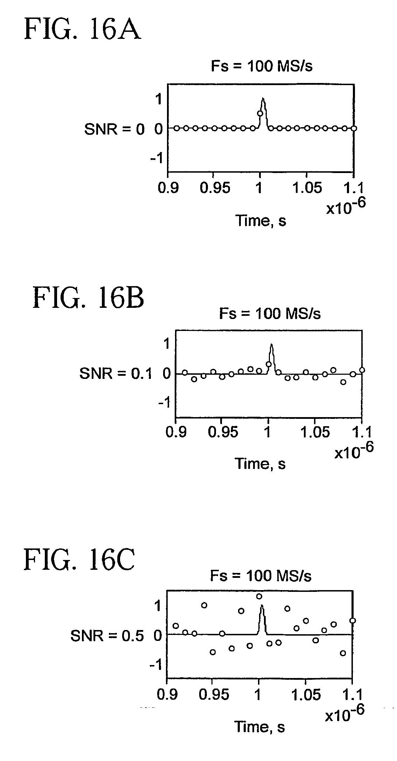

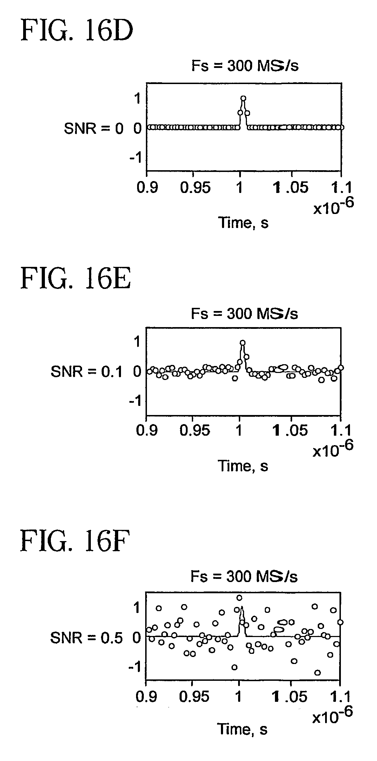

FIG. 16 shows the extent of sampled signal characteristics with the sample rate varied between 100 MS/s to 300 MS/s and noise to signal ratios (denoted by misnomer SNR) of 0, 0.1 and 0.5. The signal was generated using a Hanning window of unit amplitude and added noise was zero-mean Gaussian with a standard deviation of SNR. The centroid of the signal was defined to correspond with the "actual range". The pulse width is 10 ns.

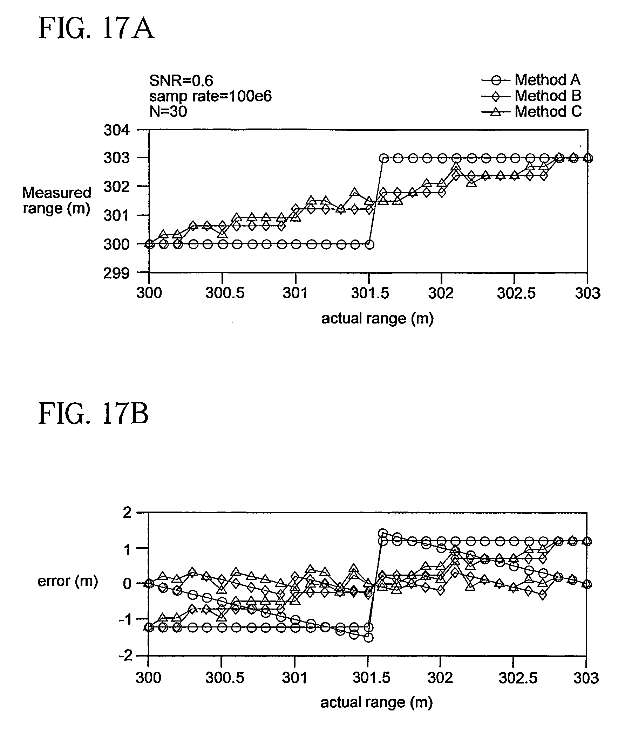

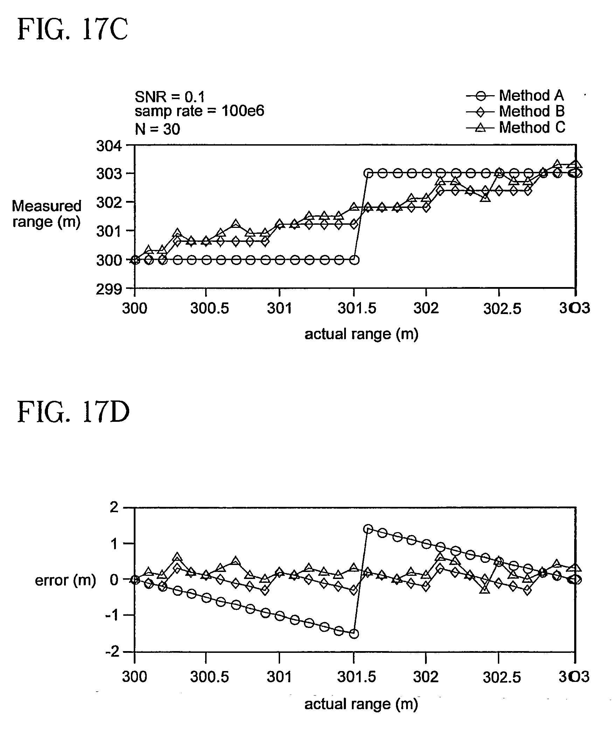

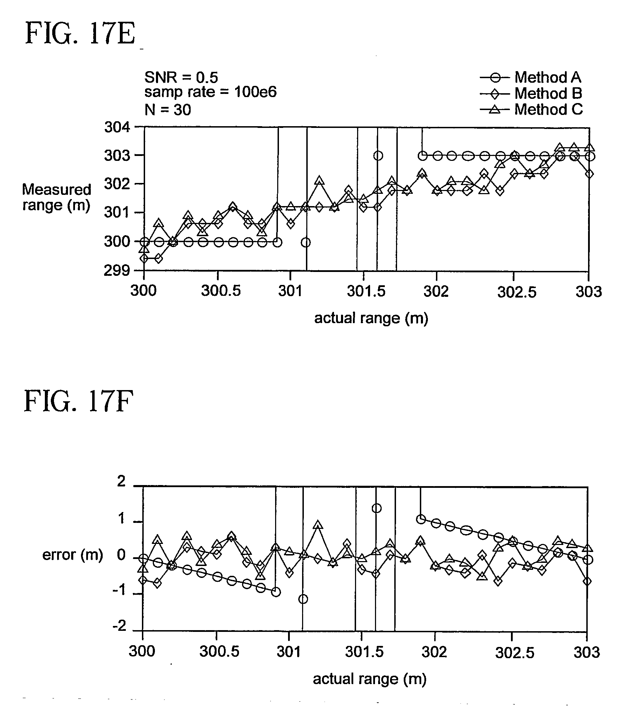

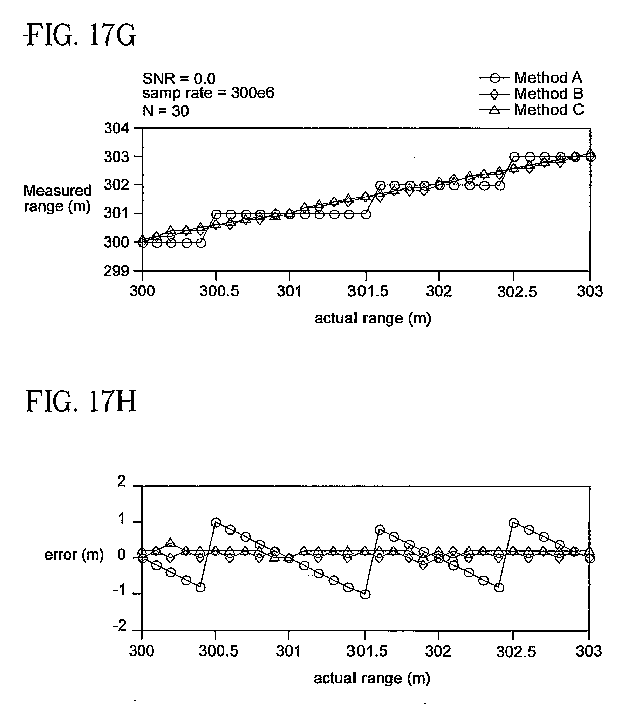

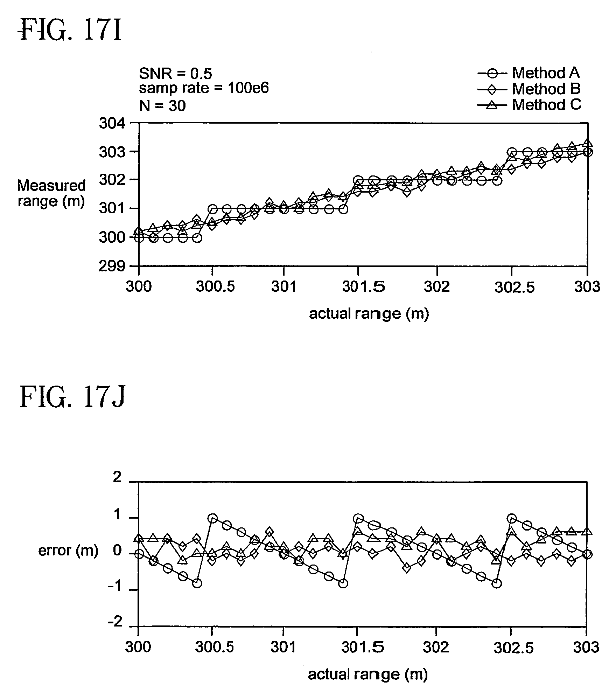

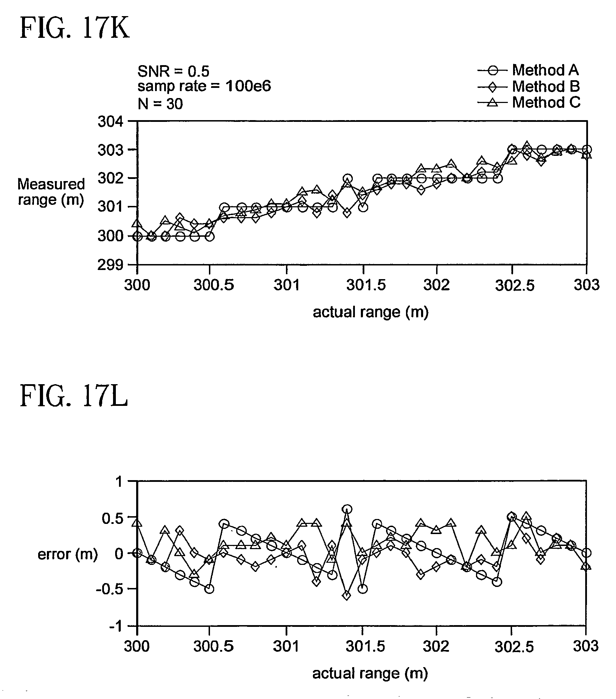

FIG. 17 compares signal processing Methods A-C for various sample rates and SNR. For method B, M=5 was used. Conclusions are as follows:

1. Methods B and C work as good or better than Method A.
2. Analysis agrees with worst-case error predictions for low-noise conditions.
3. The performance of the three methods becomes comparable at the higher sample rate with very poor SNR.

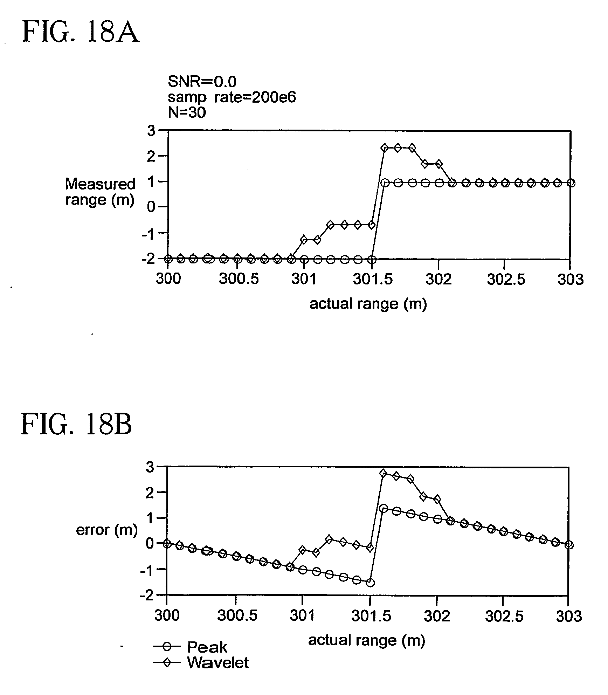

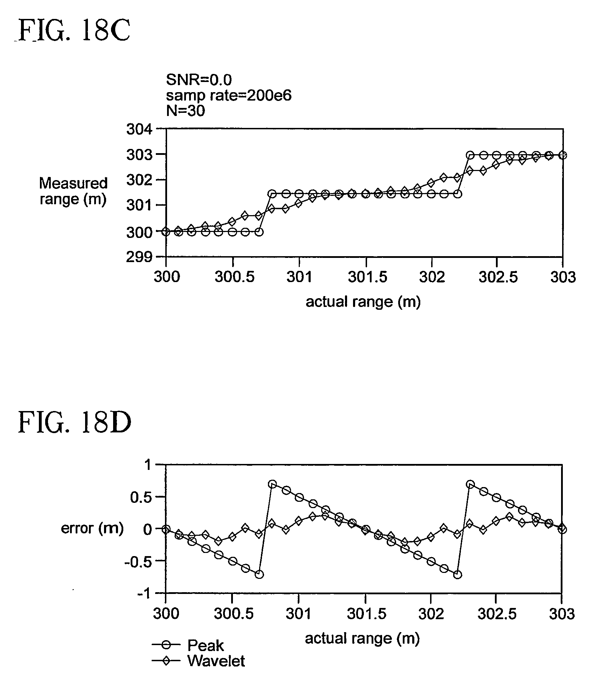

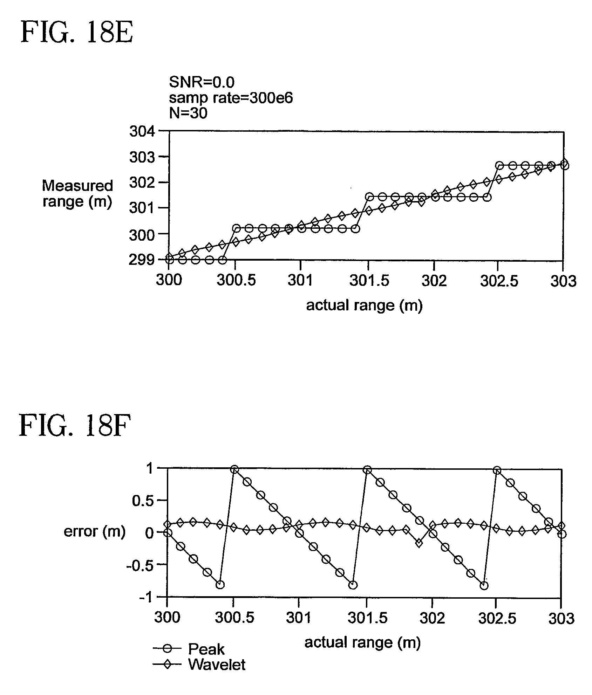

FIG. 18 compares two methods for computing the centroid of the accumulated return signal: the peak-detect method (circles) and the wavelet template waveform comparison method (diamonds). For these examples a haversine was used as the wavelet. Data accumulation according to Method A was used at various sample rates and SNR. Conclusions are as follows:

1. The wavelet template waveform comparison method provides accuracy compared to the peak-detect method in all cases except when data aliasing occurs. In this case, data aliasing corresponds to cases where the sample rate is low enough such that less than two samples may lie within the return pulse width at given times. Or, in other words, to prevent aliasing, $T_s < T_p/2$ where $T_p$ is the pulse width. To prevent aliasing in the case of Method B, one preferably has $T_s < M T_p/2$.

2. The performance of the peak detect method and the wavelet template waveform comparison method become comparable at non-aliasing sample rates when the SNR becomes very poor.

The invention can be utilized in systems that require a high accuracy and precision in the timing of when a waveform arrives at the timing sensor detector of the system. The invention provides a beneficial method for determining the time when a target wave 26 arrives at the sensing detector 24. In the invention, the wavelet correlation wavelet template waveform comparison method is utilized to time the arrival of the magnetically induced strain pulse wave that travels at sonic speed along a magnetostrictive sensor waveguide 40. The invention is used to determine the travel time of the magnetically induced strain pulse wave from its interacting magnetic fields (interaction of interrogation pulse magnetic field with the magnetic field of the coupling hub sensor magnetic target ring 36) induced origination point along the magnetostrictive sensor waveguide body length 40 to the sensor element detection head sense EM coil 38, which travel time can be used to determine the length of the travel that indicates the position of the induced origination point along the length of sensor waveguide body 40 and the position of the coupling hub sensor target magnetic ring 36.

## Claims

1. A method of measuring a magnetostrictive sensor pulse, said method comprising the steps of:

    providing a digital buffer circuit (20) connected via an analog to digital converter to an analog waveform detector (24) for receiving and digitising a pulse waveform (26) from a magnetostrictive waveguide (40),
    providing a template waveform, receiving said pulse waveform into said digital buffer circuit (20), and comparing said received pulse waveform with said template waveform to determine an arrival time of said pulse waveform.

2. A method as claimed in claim 1, said method including providing an interrogation pulse generator (32) coupled to said magnetostrictive waveguide (40), outputting an interrogation pulse (34) from said interrogation pulse generator (32) into said magnetostrictive waveguide (40), wherein receiving said pulse waveform into said digital buffer circuit (20) includes receiving a returned pulse waveform into said digital buffer circuit (20).

3. A method as claimed in claim 2, wherein said waveform detector (24) and said buffer circuit (20) are synchronised with said interrogation pulse generator (32).

4. A method as claimed in claim 1, wherein said waveform detector (24) is comprised of a sense-coil (38).

5. A method as claimed in claim 1, wherein correlating to determine said arrival time of said pulse waveform includes determining a time in the received pulse waveform where correlation between said received pulse waveform and said template waveform is at a maximum.

6. A method as claimed in claim 1, wherein receiving a pulse waveform into said buffer circuit (20) includes inputting a measured amplitude at a periodic sampling rate.

7. A method as claimed in claim 6, wherein said periodic sampling rate is at least 1 MHz.

**8.** A method as claimed in claim 3, wherein outputting an interrogation pulse from said interrogation pulse (32) generator (40) into said magnetostrictive waveguide comprises outputting an interrogation pulse at a rate of at 0.5 kHz and receiving a pulse waveform into said buffer circuit (20) includes inputting a measured amplitude at a periodic sampling rate of at least 1 MHz.

**9.** A method as claimed in claim 1, wherein providing a template waveform includes providing a mexican hat template waveform.

**10.** A magnetostrictive sensor system, said magnetostrictive sensor system comprised of a magnetostrictive waveguide (40), an analog waveform detector (24) for receiving a magnetostrictive pulse waveform from said magnetostrictive waveguide (40), **characterised by** further comprising a comparing processor (50) with a template waveform for comparing said received magnetostrictive pulse waveform with said template waveform to determine an arrival time of said pulse waveform, and a digital buffer circuit (20) connected via an analog to digital converter to said analog waveform detector (24) with said digital buffer circuit (20) in communication with said comparing processor (50).

**11.** A system as claimed in claim 10, said system comprised of a magnetostrictive interrogation pulse generator (32) for outputting an interrogation pulse (34) into said magnetostrictive waveguide (40).

**12.** A system as claimed in claim 10, wherein said waveform detector (24) is comprised of a sense-coil (38).

**13.** A system as claimed in claim 11, wherein said magnetostrictive interrogation pulse generator (32) outputs an interrogation pulse with an interrogation pulse duration in the range of about .9-2 $\mu$s.

**14.** A system as claimed in claim 11, wherein said magentostrictive interrogation pulse generator (32) outputs an interrogation pulse with a variable interrogation pulse duration.

**Patentansprüche**

**1.** Verfahren zur Messung eines magnetostriktiven Sensorimpulses, umfassend die folgenden Schritte:

Schaffung einer digitalen Pufferschaltung (20), die über einen Analog-zu-Digital-Wandler an einen analogen Wellenform-Detektor (24) angeschlossen ist, um eine Impuls-Wellenform (26) von einer magnetostriktiven Wellenführung (40) zu empfangen und zu digitalisieren, und

Schaffung einer Schablonen-Wellenform, Empfangen der Impuls-Wellenform in der digitalen Pufferschaltung (20) und Vergleichen der besagten empfangenen Impuls-Wellenform mit der Schablonen-Wellenform, um eine Ankunftszeit der Impuls-Wellenform zu bestimmen.

**2.** Verfahren nach Anspruch 1, **dadurch gekennzeichnet, dass** zu dem Verfahren die Schaffung eines Abfrageimpuls-Generators (32) gehört, der mit der magnetostriktiven Wellenführung (40) gekoppelt ist, sowie die Ausgabe eines Abfrageimpulses (34) von dem Abfrageimpuls-Generator (32) zu der magnetostriktiven Wellenform (40), wobei der Empfang der Impuls-Wellenform in der digitalen Pufferschaltung (20) den Empfang einer in die digitale Pufferschaltung (20) zurückgeführten Impuls-Wellenform beinhaltet.

**3.** Verfahren nach Anspruch 2, **dadurch gekennzeichnet, dass** der Wellenformdetektor (24) und die Pufferschaltung (20) mit dem Abfrageimpuls-Generator (32) synchronisiert sind..

**4.** Verfahren nach Anspruch 1, **dadurch gekennzeichnet, dass** der Wellenform-Detektor (24) eine Richtungsspule (38) aufweist.

**5.** Verfahren wie in Anspruch 1, **dadurch gekennzeichnet, dass** zur Zuordnung zur Bestimmung der Ankunftszeit der Impuls-Wellenform die Bestimmung einer Zeit für die empfangene Impuls-Wellenform gehört, in der die Zuordnung der empfangenen Impuls-Wellenform und der Schablonen-Wellenform ein Maximum beträgt.

**6.** Verfahren wie in Anspruch 1, **dadurch gekennzeichnet, dass** zum Empfang einer Impuls-Wellenform in der Pufferschaltung (20) das Eingeben einer gemessenen Amplitude in einem periodischen Probentakt gehört.

**7.** Verfahren wie in Anspruch 6, **dadurch gekennzeichnet, dass** der periodische Probentakt wenigstens 1 MHz beträgt.

8. Verfahren nach Anspruch 3, **dadurch gekennzeichnet, dass** das Aussenden eines Abfrageimpulses (32) von einem Abfrageimpuls-Generator (40) in die magnetostriktive Wellenführung das Aussenden eines Abfrageimpulses in einer Rate von 0,5 kHz beinhaltet, und dass der Empfang einer Impulswellenform in der Pufferschaltung (20) die Eingabe einer gemessenen Amplitude in einem periodischen Probentakt von wenigstens 1 MHz beinhaltet.

9. Verfahren nach Anspruch 1, **dadurch gekennzeichnet, dass** eine Schablonen-Wellenform eine Mexican-Hat-Wellenform aufweist.

10. Magnetostriktives Sensorsystem, umfassend eine magnetostriktive Wellenführung (40) und einen analogen Wellenform-Detektor (24) zum Empfang einer magnetostriktiven Impuls-Wellenform von der magnetostriktiven Wellenführung (40), ferner **gekennzeichnet durch** einen Vergleichsprozessor (50) mit einer Schablonen-Wellenform zum Vergleichen der empfangenen magnetostriktiven Impuls-Wellenform mit der Schablonen-Wellenform zwecks Bestimmung einer Ankunftszeit der Impuls-Wellenform, und **durch** eine digitale Pufferschaltung (20), die über einen Analog-/DigitalWandler mit dem analogen Wellenform-Detektor (24) verbunden ist, wobei die digitale Pufferschaltung (20) mit dem Vergleichsprozessor (50) in Verbindung steht.

11. System nach Anspruch 10, **dadurch gekennzeichnet, dass** das System einen magnetostriktiven Abfrageimpuls-Generator (32) aufweist, der dazu dient, einen Abfrageimpuls (34) in die magnetostriktive Wellenführung (40) abzugeben.

12. System nach Anspruch 10, **dadurch gekennzeichnet, dass** der Wellenform-Detektor (24) eine Richtungsspule (38) aufweist.

13. System nach Anspruch 11, **dadurch gekennzeichnet, dass** der magnetostriktive Frageimpuls-Generator (32) einen Abfrageimpuls mit einer Abfrageimpulsdauer im Bereich von etwa 0,9 bis 2 μs abgibt.

14. System nach Anspruch 11, **dadurch gekennzeichnet, dass** der magnetostriktive Abfrageimpuls-Generator (32) einen Abfrageimpuls mit einer variablen Abfrageimpulsdauer abgibt.


**Revendications**

1. Procédé de mesure d'une impulsion de capteur magnétostrictif, ledit procédé comprenant les étapes consistant :

   - utiliser un circuit tampon numérique (20) connecté par l'intermédiaire d'un convertisseur analogique-numérique à un détecteur de forme d'onde analogique (24) pour recevoir et numériser une forme d'onde d'impulsion (26) provenant d'un guide d'onde magnétostrictif (40) ;
   - produire une forme d'onde de référence, recevoir ladite forme d'onde d'impulsion dans ledit circuit tampon numérique (20) et comparer ladite forme d'onde d'impulsion reçue avec ladite forme d'onde de référence pour déterminer un temps d'arrivée de ladite forme d'onde d'impulsion.

2. Procédé selon la revendication 1, ledit procédé comprenant l'utilisation d'un générateur d'impulsion d'interrogation (32) couplé audit guide d'onde magnétostrictif (40), l'émission d'une impulsion d'interrogation (34) à partir dudit générateur d'impulsion d'interrogation (32) dans ledit guide d'onde magnétostrictif (40), la réception de ladite forme d'onde d'impulsion dans ledit circuit tampon numérique (20) comprenant la réception, dans ledit circuit tampon numérique (20), d'une forme d'onde d'impulsion renvoyée.

3. Procédé selon la revendication 2, dans lequel ledit détecteur de forme d'onde (24) et ledit circuit tampon (20) sont synchronisés avec ledit générateur d'impulsion d'interrogation (32).

4. Procédé selon la revendication 1, dans lequel ledit détecteur de forme d'onde (24) comprend une bobine de détection (38).

5. Procédé selon la revendication 1, dans lequel la corrélation pour déterminer ledit temps d'arrivée de ladite forme d'onde d'impulsion comprend la détermination d'un temps dans la forme d'onde d'impulsion reçue auquel une corrélation entre ladite forme d'onde d'impulsion reçue et ladite forme d'onde de référence est à un maximum.

**6.** Procédé selon la revendication 1, dans lequel la réception d'une forme d'onde d'impulsion dans ledit circuit tampon (20) comprend, à une fréquence d'échantillonnage périodique, l'entrée d'une amplitude mesurée.

**7.** Procédé selon la revendication 6, dans lequel ladite fréquence d'échantillonnage périodique est d'au moins 1 MHz.

**8.** Procédé selon la revendication 3, dans lequel l'émission d'une impulsion d'interrogation à partir dudit générateur (40) d'impulsion d'interrogation (32) dans ledit guide d'onde magnétostrictif comprend l'émission d'une impulsion d'interrogation à une fréquence d'au moins 0,5 KHz et la réception d'une forme d'onde d'impulsion dans ledit circuit tampon (20) comprend l'entrée, à une fréquence d'échantillonnage périodique d'au moins 1 MHz, d'une amplitude mesurée.

**9.** Procédé selon la revendication 1, dans lequel la production d'une forme d'onde de référence comprend la production d'une forme d'onde de référence en forme de chapeau mexicain.

**10.** Système de capteur magnétostrictif, ledit système de capteur magnétostrictif comprenant un guide d'onde magnétostrictif (40), un détecteur de forme d'onde analogique (24) destiné à recevoir une forme d'onde d'impulsion magnétostrictive provenant dudit guide d'onde magnétostrictif (40), **caractérisé par le fait qu'**il comprend en outre un processeur de comparaison (50) avec une forme d'onde de référence pour comparer ladite forme d'onde d'impulsion magnétostrictive reçue avec ladite forme d'onde de référence pour déterminer un temps d'arrivée de ladite forme d'onde d'impulsion, et un circuit tampon numérique (20) connecté par l'intermédiaire d'un convertisseur analogique-numérique audit détecteur de forme d'onde analogique (24), avec ledit circuit tampon numérique (20) en communication avec ledit processeur de comparaison (50).

**11.** Système selon la revendication 10, ledit système comprenant un générateur d'impulsion d'interrogation magnétostrictif (32) pour émettre une impulsion d'interrogation (34) dans ledit guide d'onde magnétostrictif (40).

**12.** Système selon la revendication 10, dans lequel ledit détecteur de forme d'onde (24) comprend une bobine de détection (38).

**13.** Système selon la revendication 11, dans lequel ledit générateur d'impulsion d'interrogation magnétostrictif (32) émet une impulsion d'interrogation avec une durée d'impulsion d'interrogation se situant dans la plage d'environ 0,9 à 2 μs.

**14.** Système selon la revendication 11, dans lequel ledit générateur d'impulsion d'interrogation magnétostrictif (32) émet une impulsion d'interrogation avec une durée d'impulsion d'interrogation variable.

FIG. 1A

# FIG. 1B

Interrrogation
Pulse
Generator

32

34  Interrogation
Pulse

24

26

30

40

Current
Drive

i

i

1

38

0.  26

X

N

36

1

22

ADC

60
26

20

Digital Buffer Circuit

62

Comparing
Processor

Template
Waveform

28

48

50

Arrival Time of Waveform

Distance Traveled by Waveform

# FIG. 1D

EP 1 673 592 B1

FIG. 2

# FIG. 3

| Interrogation | |
|---|---|
| Pulse Fixed Delay, $t_D$ | Zero Crossing Time, $t_Z$ |
| A/D Sample Enable | |
| Analog Response Waveform | |
| Sampled (HighSpeed) Analog Response | |
| Sampled (LowSpeed) Analog Response | 62 |

FIG. 4

Time (μs)

— — — Carrier
·—·—· Envelope
——— Pulse

# FIG. 5

Legend:
- Sync Pulse
- 3-Period Cos Modulated Cos
- 4-Period Cos Modulated Cos
- Mexican Hat Wavelet

FIG. 6A

Return
Waveform

CP

Time (µs)

— Analog
o Sampled

FIG. 6B

Sliding
Wavelet

WT

Wavelet Translation Time τ (µs)

FIG. 6C

Correlation

0   1   2   3   4   5   6   7   8   9   10

Wavelet Translation Time τ (µs)

FIG. 6D

Quadratic
Error

0   1   2   3   4   5   6   7   8   9   10

Wavelet Translation Time τ (µs)

# FIG. 7A

## Matlab Script Example 1

```
%  establish search interval (a,b)
        al = tsamp(kl-3);
        bl = tsamp(kl+3);

%  Slide template according to bisection algorithm

        tol = 1e-6;
        % Compute cost function at the two search interval boundaries
        pulse_al = -syncgen( w0_est, al, tsamp, pulsetype_est );
        pulse_bl = -syncgen( w0_est, bl, tsamp, pulsetype_est );
        err_al = pulse_al - bufl;
        err_bl = pulse_bl - bufl;
        J_al = sum(err_al .* err_al);
        J_bl = sum(err_bl .* err_bl);

        z = 1; i = 0; del=9999;

    while z;  i = i+1;
        pl = (al + bl) / 2;                     % Bisect ...
        pulse_pl = -syncgen( w0_est, pl, tsamp, pulsetype_est );
        err_pl = pulse_pl - bufl;
        J_pl(i) = sum(err_pl .* err_pl);        % and compute new cost function
        if (J_al-J_pl(i)) < (J_bl-J_pl(i)),     % Decide which segment to bisect
next
            bl = pl;  J_bl = J_pl(i);
        else, al = pl;  J_al = J_pl(i);   end;
        if i>1; del = abs(J_pl(i) - J_pl(i-1)); end    % Decide if its time to stop
        if del < tol; z = 0; end;                      % Decide if its time
to stop
        end
```

# FIG. 7B

Cost Function, J

Time, s

FIG. 8

## FIG. 9

## FIG. 10

FIG. 11

Wave 1: direct
Wave 2: reflection

FIG. 12

## FIG. 13

## FIG. 14

# FIG. 15

FIG. 16A

FIG. 16B

FIG. 16C

FIG. 16D

FIG. 16E

FIG. 16F

## FIG. 17A

SNR=0.6
samp rate=100e6
N=30

Method A, Method B, Method C

Measured range (m) vs actual range (m)

## FIG. 17B

error (m) vs actual range (m)

# FIG. 17C

SNR = 0.1
samp rate = 100e6
N = 30

Method A
Method B
Method C

Measured range (m)

actual range (m)

# FIG. 17D

error (m)

actual range (m)

## FIG. 17E

SNR = 0.5
samp rate = 100e6
N = 30

Method A, Method B, Method C

Measured range (m) vs actual range (m)

## FIG. 17F

error (m) vs actual range (m)

## FIG. 17G

SNR = 0.0
samp rate = 300e6
N = 30

Legend: Method A, Method B, Method C

Measured range (m) vs actual range (m)

## FIG. 17H

error (m) vs actual range (m)

## FIG. 17I

SNR = 0.5
samp rate = 100e6
N = 30

—⊖— Method A
—◇— Method B
—△— Method C

## FIG. 17J

## FIG. 17K

SNR = 0.5
samp rate = 100e6
N = 30

Legend: Method A, Method B, Method C

Measured range (m) vs actual range (m)

## FIG. 17L

error (m) vs actual range (m)

FIG. 18A

FIG. 18B

## FIG. 18C

SNR=0.0
samp rate=200e6
N=30

Measured range (m)

actual range (m)

## FIG. 18D

error (m)

actual range (m)

—⊖— Peak
—◇— Wavelet

## FIG. 18E

SNR=0.0
samp rate=300e6
N=30

## FIG. 18F

—⊖— Peak
—◇— Wavelet

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030146747 A
- US 60374752 B
- US 42132503 A
- US 20040024499 A1